# FASCICULE DE BREVET EUROPEEN

(11) **EP 1 979 983 B1**
(45) Date de publication et mention de la délivrance du brevet: **03.06.2009**
(21) Numéro de dépôt: 07731569.5
(22) Date de dépôt: 02.02.2007
(51) Int. Cl.: H01P 1/38

(54) **DISPOSITIF MONOLITHIQUE DE TYPE CIRCULATEUR**
MONOLITISCHER ZIRKULATOR
CIRCULATOR TYPE MONOLITHIC DEVICE

(30) Priorité: 02.02.2006 FR 0650365
(43) Date de publication de la demande: 15.10.2008
(73) Titulaire: Centre National de la Recherche Scientifique, 75794 Paris Cedex 16 (FR)
(72) Inventeur: COUSTOU, Antony, F-46500 Alvignac (FR); PLANA, Robert, F-31590 Verfeil (FR)
(74) Mandataire: de Beaumont, Michel
(86) Numéro de dépôt international: PCT/FR2007/050742
(87) Numéro de publication internationale: WO 2007/090982

(56) Documents cités:
- EP-A- 1 209 756
- DE-A1- 19 508 429
- DE-B1- 2 807 813

## Description

### Domaine de l'invention

La présente invention concerne des circulateurs faisant partie d'un dispositif monolithique tel qu'un circuit intégré. La présente invention concerne plus particulièrement les circulateurs utilisés dans des systèmes d'identification par radiofréquence.

### Exposé de l'art antérieur

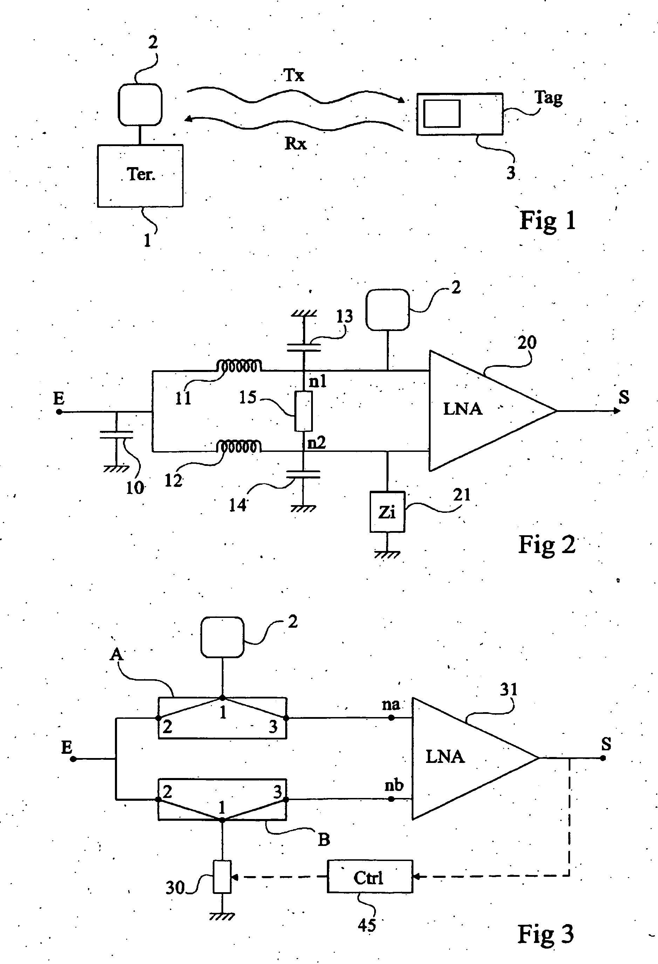

La figure. 1 est un schéma d'un système d'identification par radiofréquence. Un terminal 1 muni d'une antenne 2 permet d'identifier un dispositif transpondeur 3. Le dispositif transpondeur 3 peut êtres une étiquette collée sur une marchandise ou bien un badge porté par une personne. Le terminal 1 peut être fixe ou mobile selon l'utilisation envisagée.

L'identification du dispositif transpondeur 3 se fait de la façon suivante. Le terminal émet par l'intermédiaire de l'antenne 2 un signas électromagnétique Tx. Quand le dispositif transpondeur 3 reçoit le signal électromagnétique Tx, il émet en retour un signal électromagnétique Rx qui est capté par l'antenne 2 et traité ensuite par le terminal 1.

Les signaux électromagnétiques Tx et Rx étant émis et reçus par une même antenne, le terminal 1 doit être équipé d'un dispositif permettant de "séparer" ces deux signaux. Pour ce faire, on utilise généralement un dispositif appelé circulateur.

La figure 2 est un schéma d'un exemple connu de circulateur. Il comprend un condensateurs 10 placé entre une entrée E et la masse. Il comprend en outre deux bobines 11 et 12 dont un côté est relié à l'entrée E et les autres côtés sont respectivement reliés à un noeud n1 et à un noeud n2. Des condensateurs 13 et 14 sont placés respectivement entre le noeud n1 ou n2 et la masse. Une résistance 15 est placée entre les noeuds n1 et n2. Les entrées d'un amplificateur différentiel à faible bruit LNA 20 sont reliées aux noeuds n1 et n2. L'amplificateur différentiel LNA 20 fournit un signal sur une sortie S. L'antenne 2 d'émission-réception des signaux électromagnétiques, Tx et Rx est reliée au noeud n1. Par ailleurs, un élément de charge 21 est placé entre le noeud n2 et la masse. L'impédance Zi de l'élément de charge 21 est égale à l'impédance de l' antenne 2. Ce circulateur est en fait constitué d'un pont de. Wilkinson en éléments localisés suivi d'un amplificateur différentiel.

Lors d'une émission, le terminal 1 fournit un signal électrique sur l'entrée E du circulateur. Ce signal ses propage jusqu' à l'antenne 2 où un signal électromagnétique est émis. On notera que le signal électrique se propage également à travers la bobine 12 jusqu'au noeud n2. Les signaux électriques reçus sur les entrées de l'amplificateur différentiel 20 sont théoriquement identiques en amplitude et en phase. Le signal fourni par l'amplificateur différentiel 20 est alors nul ou très faible.

Lorsqu'un signal Rx est émis par le dispositif transpondeur 3, l'antenne 2 capte ce signal et le transmet au noeud n1. Ce signal se propage en outre à travers le circulateur jusqu'à atteindre le noeud n2 où il arrive fortement atténue. Les composants du circulateur ont des valeurs telles que les signaux présents sur les entrées de l'amplificateur différentiel 20 sont en opposition de phase. Les différences entre ces deux signaux sont amplifiées et transformées par l'amplificateur 20 qui fournit sur la sortie S du circulateur une reconstitution du signal Rx.

Un inconvénient du circulateur précédemment décrit est que la puissance d'un signal Tx fourni par le terminal 1 doit rester faible pour ne pas perturber le fonctionnement de l'amplificateur différentiel LNA 20. En pratique, cette limitation de la puissance d'émission du terminal 1 empêche de détecter des dispositifs transpondeurs situés à plus de 10 cm du terminal 1.

De plus, le pouvoir séparateur du circulateur, ou autrement dit sa capacité à permettre une reconnaissance d'un signal Rx de puissance bien inférieure à un signal Tx émis en parallèle, est limité. En conséquence, la puissance du signal Rx ne doit pas être trop faible comparativement à celle du signal Tx. Pour ce faire, il faut soit que le dispositif transpondeur soit proche du terminal 1, soit que le dispositif transpondeur dispose d'une batterie interne. Or l'utilisation d'une batterie interne augmente considérablement le coût et la taille de transpondeurs tels que des étiquettes ou des badges. De plus, la consommation électrique des transpondeurs étant généralement importante et la capacité de stockage des batteries réduite, la durée de vie dés transpondeurs est bien souvent limitée.

En outre, le pouvoir séparateur du circulateur est en pratique bien inférieur à son pouvoir "théorique" car l'impédance de l'antenne 2 varie de façon significative en fonction des conditions d'utilisation. L'impédance de l'antenne dépend notamment de la présence ou non d' éléments conducteurs électriques à proximité de l'antenne.

### Résumé de l'invention

Un objet de la présente invention est de prévoir un circulateur qui permette de transférer jusqu'à une antenne des signaux à émettre présentant une puissance élevée sans perturber la réception par cette même antenne de signaux présentant une puissance beaucoup plus faible.

Un autre objet de la présente invention est de prévoir un tel circulateur qui présente un pouvoir séparateur inchangé quelle que soit l'impédance de l'antenne à laquelle il est relié.

Un autre objet de la présente invention est de prévoir un tel circulateur qui puisse être fabriqué de façon monolithique.

Un autre objet de la présente invention est de prévoir un tel circulateur qui permette d'émettre et de recevoir des signaux électromagnétiques présentant une fréquence de quelques GHz.

Pour atteindre tout ou partie de ces objets, la présente invention prévoit un circulateur monolithique, destiné à être relié à une antenne pour émettre et recevoir des signaux haute fréquence, comprenant : un amplificateur différentiel à deux entrées apte à fournir un signal sur une sorte du circulateurs, et deux coupleurs 3dB comportant chacun des première, deuxième et troisième bornes d'accès, les deuxièmes bornes étant connectées à une entrée E du circulateur, chaque troisième borne étant connectée à une entrée de l'amplificateur, les premières bornes étant respectivement destinées à être reliées à L'antenne et à un élément de charge présentant une impédance proche de celle de l'antenne.

Selon un mode de réalisation du circulateur susmentionné, chaque coupleur comporte une résistance et une bobine à point milieu placées en parallèle entre ses première et troisième bornes, les deux parties de chaque bobine à point milieu étant couplées magnétiquement, le point milieu d'une bobine d'un coupleur étant connecté à sa première borne.

Selon un mode de réalisation du circulateur décrit ci-dessus, chaque coupleur comprend en outre un condensateur en parallèle sur la résistance et la bobine à point milieu du coupleur considéré.

Selon un mode de réalisation du circulateur décrit ci-dessus, l'impédance de l'antenne est proche de celle d'une résistance de valeur R, la valeur des résistances de chacune coupleur étant environ égale à quatre fois R, l'impédance d'une entrée de l'amplificateur différentiel état environ égale à deux fois R, l'impédance de sortie d'un circuit connecté sur l'entrée du circulateur étant environ égale à deux fois R.

Selon un mode de réalisation du circulateur décrit ci-dessus, l'impédance de l'élément de charge est réglable.

Selon un mode de réalisation du circulateur décrit ci-dessus, le cïrculateur comprend un circuit de contrôle apte à modifier l'impédance de l'élément de charge en fonction de la tension relevée en sortie de l'amplificateur différentiel.

Selon un mode de réalisation du circulateurs décrit ci-dessus, l'élément de charge comprend une première résistance et une première source de tension en série entre la masse et un premier noeud intermédiaire entre les cathodes de deux premières diodes de type varactor, une seconde résistance et une seconde source de tension en série entre la masse et un second noeud intermédiaire entre les cathodes de deux secondes diodes de type varactor, l'anode de l'une des premières diodes étant reliée à la masse par l'intermédiaire d'une troisième résistance, l'anode d'une des secondes diodes étant connectée à la masse, l'autre des secondes diodes étant reliée à la masse par l'intermédiaire d'une quatrième résistance, une bobinie étant placée entre l'anode de l'autre des premières diodes et l'anode de l'autre des secondes diodes.

Selon un mode de réalisation du circulateur décrit ci-dessus, le circuit de contrôle comprend un premier ensemble de blocus qui reçoit la sortie du circulateur et qui est relié à des première et seconde boucles d'asservissement, le premier ensemble de blocs comprenant un dispositif d'extraction de l'amplitude du signal en sortie du circulateur, suivi d'un filtre passe-bas et d'un dispositif dérivateur, chaque boucle d'asservissement comprenant les éléments suivants : un bloc diviseur recevant sur une entrée nominateur la sortie du dispositif dérivateur la sortie du bloc diviseur étant connectée à une borne positive d'un comparateur, la sortie du comparateur étant reliée à un dispositif de stabilisation dont la sortie est connectée à l'entrée d'un bloc intégrateur, un bloc dérivateur étant placé entre la sortie du bloc intégrateur et une entrée dénominateur du bloc diviseur, la seconde boucle comprenant en outre un bloc tampon placé entre son comparateur et son dispositif de stabilisation et recevant la sortie du bloc dérivateur de la première boucle, la sortie du bloc tampon étant égale à la sortie du comparateur de la seconde bouclé ou nulle selon que la sortie du bloc dérivateur de la première boucle est respectivement nulle ou non nulle, les sorties des blocs intégrateurs des première et seconde boucles fournissant respectivement des tensions égales aux tensions appliquées par les première et seconde sources de tension de l'élément de charge.

Selon un mode de réalisation du circulateur susmentionné, le dispositif dérivateur est constitué d'un condensateur et d'une résistance en série placés entre la sortie du filtre passe-bas et la masse, le noeud intermédiaire entre le condensateur et la résistance étant connecté aux entrées N des blocs diviseurs des boucles d'asservissement, le dispositif de stabilisation de chaque boucle d'asservissement comprend des première et seconde bascules de Schmitt, l'entrée de la première bascule étant reliée au comparateur de la boucle considérée, une première résistance placée entre les bascules un condensateur placé entre l'entrée de la seconde bascule et la masse et une seconde résistance placée entre la sorte de la seconde bascule et l'entrée du bloc intégrateur de la boucle d'asservissement considérée, le blocs dérivateur de chaque boucle d'asservissement comprend un condensateur et une résistance en série entre l'entrée du bloc et la masse, le noeud intermédiaire entre le condensateur et la résistance constituant la sortie du bloc, et le bloc intégrateur de chaque boucle d'asservissement comprend un amplificateur, différentiel ainsi qu'un condensateur et une résistance placées en parallèle' entre la sortie et l'entrée négative de l'amplificateur différentiel, les bornes positive et négative de l'amplificateur étant respectivement connectées à la masse et à la sortie du dispositif de stabilisation de la boucle considérée.

La présente invention prévoit en outre un terminal de réception et d'émission de signaux électromagnétiques comprenant un circulateur tel que ceux décrits ci-dessus, le circulateur étant relié à une antenne.

### Brève description des dessins

Ces objets, caractéristiques et avantages, ainsi que d'autres de la présente invention seront exposés en détail dans la description suivante de modes de réalisation particuliers faite à titre non limitatif en relation avec les figures jointes parmi lesquelles:
la figure 1 est un schéma, précédemment décrit, illustrant un système d'identification par radio fréquence ;
la figure 2 est un schéma d'un circulateur connu, précédemment décrit ;
la figure 3 est un schéma d'un circulateur selon la présente invention ;
la figure 4 est un exemple de réalisation d'un circulateur selon la présente invention ;
la figure 5 est une vue de dessus d'un exemple de bobines point milieu utilisée dans le circulateur représenté en figure 4 ;
la figue 6 est un schéma électrique équivalent d'une partie du circulateur représenté en figure 4 ;
la figure 7 est un schéma électrique équivalent plus détaillé de la partie du circulateur représentée en figure 4 ;
la figure 8 est un schéma d'une variante de réalisation du circulateur représenté en figure 4 ;
la figure 9 est un schéma d'un exemple d'élément de charge pouvant être utilisé dans un circulateur selon la présente invention ;
la figure 10 est un schéma illustrant une partie d'un dispositif du circulateur représenté en figure 8 ;
la figure 11 est un diagramme illustrant lé niveau du signal de sortie du circulateur représenté en figure 3 en fonction de la tension appliquée par une source de tension de l'élément de charge représenté en figure 9 ;
la figure 12 est un schéma illustrant un système d'asservissement de l'impédance de l'élément de charge représenté en figure 9 ;
la figure 13 est un schéma plus détaillé du système d'asservissement représenté en figure 12 ; et
la figure 14 est un schéma illustrant un premier étage d'un amplificateur, différentiel à faible bruit utilisé dans un exemple de circulateur selon la présente invention.

### Description détaillée

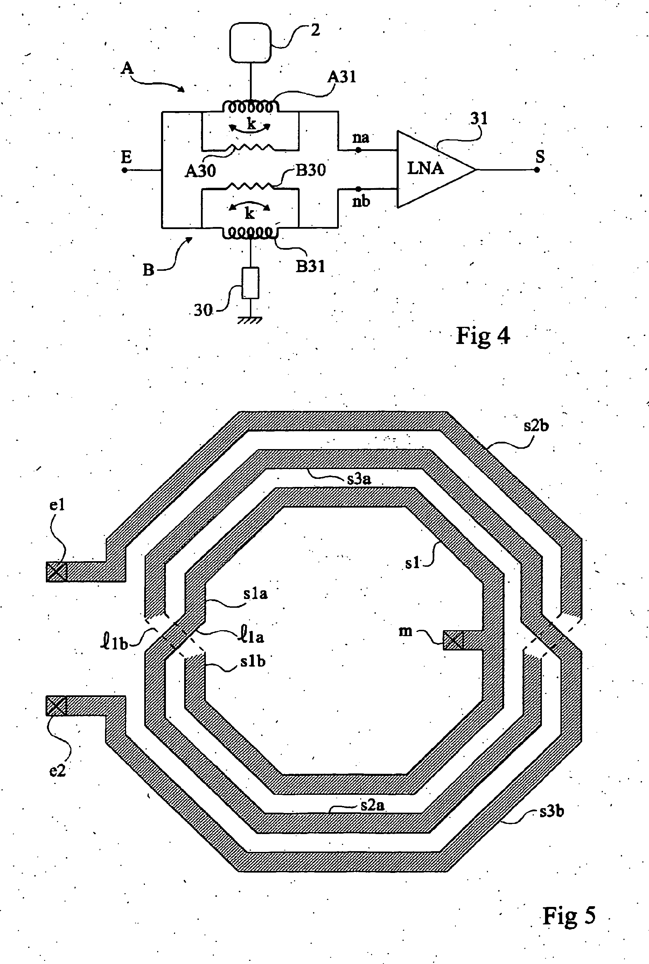

Par souci de clarté, de mêmes éléments ont été désignés par de mêmes référencés aux différentes figures et, de plus, comme celà est habituel dans la représentation des circuits intégrés, la figure 5 n'est pas tracée à l'échelle.

La figure 3 est un schéma d'un circulateur selon la présente invention. Le circulateur, comprend deux coupleurs A et B comportant chacun 3 bornes d'accès numérotées 1, 2 et 3. La borne d'accès n°1 du coupleur A est reliée à une antienne 2. La borne d'accès n°1 du coupleur B est reliée à un élément de charge 30 présentant une impédance proche dé celle de l'antenne 2. Les bornes d'accès n°2 des coupleurs A et B sont reliées à une entrée E du circulateur. Les bornes d'accès n°3 des coupleurs A et B sont respectivement connectées à des entrées na et nb d'un amplificateur différentiel faible bruit LNA 31. La sortie de l'amplificateur 31 est reliée à une sortie S du circulateur.

Les coupleurs utilisés dans le circulateur selon la présente invention sont des coupleurs de type 3dB. Les coupleurs 3dB sont tels qu'un signal arrivant sur la borné d'accès n°1 se propage jusqu'à chacune: des bornes n°2 et n°3 et qu'un signal arrivant sur la borne d'accès 2 se propage uniquement jusqu'à la borne n°1. Dans un coupleur 3dB idéal, aucun signal ne se propage entre les bornes n°2 et n°3.

Divers types de coupleurs 3dB peuvent être utilisés. Des exemples en sont des lignes couplées et un pont de Wilkinson. Un exemple de coupleur formé à partir d'une bobine à point milieu présentant deux parties couplées magnétiquement est décrit ci-après.

Lorsqu'un terminal incluant un circulateur selon la présente invention souhaite émettre un signal électromagnétique. Tx, il présente un signal électrique adéquat tx sur l'entrée E du circulateur. Le signal tx se propage entre les bornes d'accès n°2 et n°1 du coupleur A jusqu'à l'antenne 2. L'antenne 2 émet alors le signal électromagnétique Tx.

Les coupleurs existants n'étant pas parfaits, lors de cette émission, une partie du signal électrique tx se propage à travers les coupleurs, entre les noeuds n°2 et n°3, jusqu'aux noeuds na et nb qui reçoivent deux signaux "parasites" txa et txb. La puissance des signaux parasites txa et txb est cependant beaucoup plus faible que celle du signal électrique tx présent sur l'entrée E. Cette forte réduction de puissance permet de ne pas perturber le fonctionnement de l'amplificateur différentiel. De plus, les signaux parasites txa et txb sont de même amplitude et en phase. Leur impact sur la valeur du signal fourni en sortie S du circulateur est donc négligeable. Cet impact est d'autant plus négligeable que le taux de réjection en mode commun de l'amplificateur différentiel 31 est élevé .

Lorsqu'un' signal électromagnétique Rx est émis par le dispositif transducteur 3 et reçu par l'antenne 2, un signal électrique rx "entre" dans le circulateur au niveau de la borne d'accès n°1 du coupleur A. Le signal rx se propage vers la borne d'accès n°3 du coupleur A pour atteindre l'entrée na de l'amplificateur' 31 sous la forme d'un signal rxa. Le signal rx se propage également vers la borne d'accès n°2 du coupleur A pour rejoindre la borne d'accès n°2 du coupleur B. Un signal de très faible puissance ressort alors par la borne d'accès n°3 du coupleur B pour atteindre l'entrée nb de l'amplificateur 31 sous la forme d'un signal rxb. Les signaux rxa et rxb sont en opposition de phase, l'amplitude du signal rxb étant beaucoup plus faible que celle du signal rxa. L'amplificateur différentiel fournit alors sur la sortie S un signal correspondant à une reconstitution du signal rx reçu.

Un avantage du circulateur selon la présente invention est qu'il permet d'émettre des signaux électromagnétiques présentant une puissance élevée sans perturber le fonctionnement de l'amplificateur différentiel. Ainsi, un terminal incluant un circulateur selon la présente invention peut recevoir des signaux électromagnétiques de très faible puissance et donc détecter des dispositifs transducteurs relativement éloignés du terminal.

Par ailleurs, pour pouvoir recevoir et émettre des signaux présentant une fréquence due l'ordre du GHz, les circulateurs connus doivent inclure des composants présentant des valeurs d'inductances, de capacités et de résistance très élevées. Ce qui est incompatible avec une réalisation d'un circulateur sous la forme d'un dispositif monolithique.

Au contraire, de nombreux types de coupleurs 3 dB peuvent être réalisés à partir d'un ensemble de composants "intégrables", c'est-à-dire présentant une taille raisonnable pour pouvoir être placé dans un circuit intégré.

Un avantage d'un circulateur selon la présente invention est donc qu'il peut être fabriqué de façon monolithique même lorsque la fréquence d'émission et de réception de signaux est élevée, de l'ordre du GHz.

La figure 4 est un schéma d'un mode de réalisation d'un circulateur selon la présente invention Chaque coupleur A et B comprend une résistance A30, B30 et une bobine à point milieu A31, B31, placées en parallèle entre l'entrée E du circulateur et une entrée na ou nb de l'amplificateur différentiel 31. Le point milieu de la bobine A31 est relié à l'antenne 2. Le point milieu de la bobine B31 est relié à l'élément de charge 30. Les bobines à points milieu A31 et B3i comprennent chacune deux parties de bobine couplées magnétiquement. Pour chaque bobine à point milieu, la première partie est placée entre l'entrée E et le point milieu de la bobine et la seconde partie est placée entre le point milieu et une entrée na ou nb de l'amplificateur 31. L'inductance totale de la bobine est égale à L, les première et seconde parties ayant des inductances respectivement égales à L/2.

La figure 5 est une vue de dessus d'un exemple de bobine à point milieu présentant deux parties couplées magnétiquement. C'est une bobine à point milieu couramment utilisée dans des circuits intégrées. Elle est généralement placée au-dessus d'une plaque semiconductrice hébergeant des composants semiconducteurs, dans le réseau d'interconnexions du circuit intégré. Le réseau d'interconnexions comprend plusieurs niveaux de métallisations séparés par des couches isolantes. La bobine à point milieu représentée en figure 5 est constituée de lignes métalliques placées en grande partie sur un même niveau de métallisation N, quelques lignes métalliques étant placées à un niveau de métallisation inférieur, N-1. Une spire interne s1 de forme sensiblement octogonale est formée sur le niveau de métallisation N. Les deux extrémités s1a et s1b de la spire s1 sont proches l'une de l'autre sur la gauche de la figure. L'extrémité s1a est reliée à une spire externe s2 formée en grande partie sur le niveau N et dont l'extrémité, placée sur la gauche de la figure, constitue une extrémité e1 de la bobine. De même, l'extrémité s1b de la spire interne s1 est reliée à une spire externe s3 formée sur le niveau N et dont l'extrémité, placée sur la gauche de la figure, constitue une extrémité e2 de la bobine. L'extrémité s1a de la spire s1 est reliée à la spire s2 par une portion de bobine de liaison 11a placée au niveau N. L'extrémité s1b est quant à elle reliée à la spire s3 par une portion de bobine de liaison 11b en forme de "tunnel" comprenant deux vias conducteur et une portion placée au niveau N-1 sous la portion de liaison 11a, transversalement à cette dernière. Chacune des spires s2 et s3 comprend une demi-spire s2a, s3a proche de la spire s1 et s'étendant de la gauches vers la droite de la figure respectivement en dessous et au-dessus de la spire s1. Les autres demi-spires s2b et s3b des spires s2 et s3 s'étendent de la droite vers la gauche de la figure respectivement au-dessus et en dessous des demi-spires s3a et s2a. Les demi-spires s3a et s3b de la spire s3 sont reliées par une portion de bobine de liaison 13 placée au niveau N. Les demi-spires s2a et s2b de la spire s2- sont quant à elles reliées par une portion de bobine de liaison 12 en forme de "tunnel" comprenant deux vias conducteurs et une portion placée au niveau N-1 sous la portion de liaison 13, transversalement à cette dernière. Le - milieu de la portion de la spire s1 située sur la droite de la figure est relié à un plot de contact constituant un point milieu m.

La première partie, de la bobine est constituée de la spire s2 et de la moitié de la spire s1. La seconde partie de la bobine est constituée de la spire s3 et de la moitié de la spire s1. Les deux parties de la bobine sont entrelacées et couplées magnétiquement.

Dans le mode de réalisation du circulateur représenté en figure 4, l'utilisation de bobines à point milieu comportant deux parties couplées magnétiquement permet de réaliser un isolement entre l'entrée E du circulateur et les entrées na et nb de l'amplificateur 31. On notera toutefois que l'isolement entre l'entrée E et l'amplificateur 31 est d'autant mieux réalisé que les éléments connectés à chacune des bobines A31 et B31 présentent des impédances de valeurs prédéterminées telles que définies ci-après.

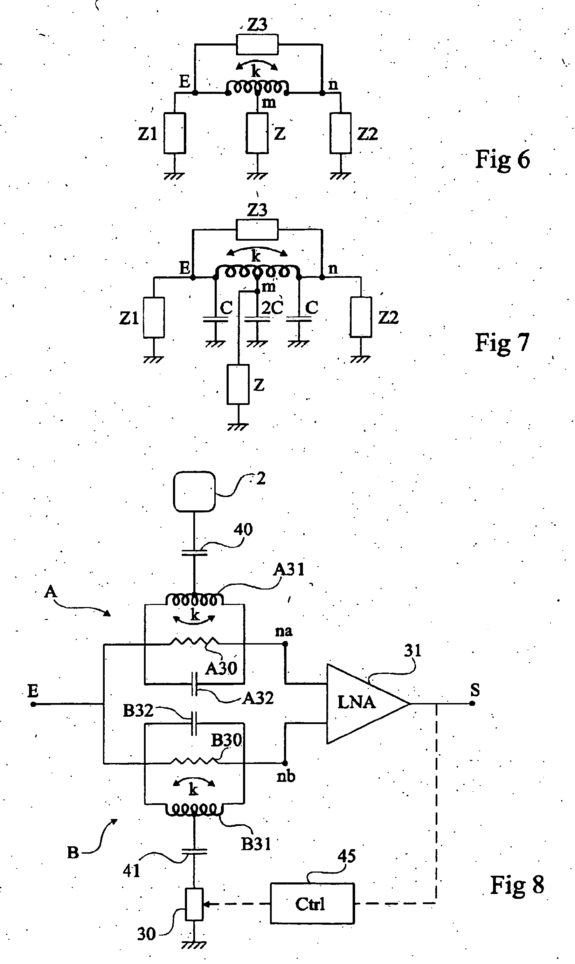

La figure 6 est un schéma électrique équivalent des éléments reliés à une des bobines A31' et B31. Le point milieu m de la bobine est connecté à l'antenne 2 ou à l'élément de charge 30 dont chacun présente une impédance Z. Une extrémité de la bobine est connectée à l'entrée E du circulateur qui est connectée à un circuit du terminal tel qu'un amplificateur de puissance présentant une impédance de sortie de valeur Z1. L'autre extrémité de la bobine est connectée à une entrée de l'amplificateur na ou nb, appelée de façon générale n dans ce schéma équivalent. Chaque entrée de l'amplificateur 31 présent une impédance Z2. Par ailleurs, les extrémités dé la bobine sont reliées par l'intermédiaire d'un élément "d'adaptation" présentant une impédance Z3. Cet élément d'adaptation comprend entre autres la résistance A30 ou B30 représentée en figure 4.

Pour que l'isolation soit "parfaite", il faut que les impédances Z1 et Z2 soient identiques et égales à deux fois l'impédance Z (Z1=Z2=2*Z). De plus, il faut que l'impédance Z3 soit égale à quatre fois Z (Z3=4*Z).

L'impédance Z de l'antenne 2, bien que fluctuante, est toujours relativement proche de celle d'une résistance R de valeur 50 ohms. Les impédances Z1 et Z2 doivent donc être sensiblement égales à 2*R, soit 100 ohms. L'impédance Z3, ou autrement dit la résistance A30 ou B30 de chaque branche, doit être sensiblement égale à 4*R, soit 200 Ohms.

La figure 7 est un schéma électrique équivalent plus détaillé que celui représenté en figure 6 qui tien compte dés éléments parasites d'une bobine à point milieu d'un dispositif monolithique. Les éléments capacitifs parasites d'une telle bobine peuvent être modélisés -de la façon suivante. Un condensateur de capacité C est placé entre chaque extrémité de la bobine et la masse et un condensateur de capacité égale à 2*C est placé entre le point milieu de la bobine et la masse. La valeur de capacité C est fonction de la taille et de la forme de la bobine utilisée. De façon générale, plus l'inductance de la bobine est élevée plus la capacité C est élévée.

L'entrée E, le point milieu m et l'entrée un sont alors reliés à des éléments présentant respectivement une impédance Z1', Z' et Z2'. L'impédance Z1' est constituée de l'impédance Z1. en parallèle avec un condensateur de capacité C. De même, l'impédance Z2' est constituée de l'impédance Z2 en parallèle avec un condensateur de capacité C. L'impédance Z' est constituée de l'impédance Z en parallèle avec un condensateur de capacité 2*C.

Les relations permettant d'assurer un isolement électrique entre l'entrée E et l'amplificateur sont alors : Z1'=Z2'=2*Z' et Z3=4*Z'.

Afin que la seconde relation soit vérifiée; un condensateur de capacité C/2 doit être placé en parallèle sur chaque résistance A31, B31. L'impédance Z3 est alors celle d'une résistance de valeur 4*R et d'un condensateurs de capacité C/2 en parallèle.

La première relation est vérifiée sans changement des impédances Z1 et Z2 précédemment définies. Autrement dit, les impédances Z1 et Z2 sont égales à la résistance R correspondant à l'impédance équivalente "moyenne" de l'antenne.

La figure 8 est un schéma d'une variante de réalisation du circulateur représenté en figure 4. Outre les éléments représentés en figure 4, le circulateur comprend dans chaque coupleur A et B un condensateur A32, B32 en parallèle, sur la résistance A30, B30 et la bobine A31, B31. La capacité de chaque condensateur A32, B32 est fixée comme décrit ci-dessus en fonction des capacités parasites de chacune des bobines A31 et B31. Le circulateur comprend en outre un condensateur 40 placé entre le point milieu de la bobine A31 et l'antenne 2. Le condensateur 40 est utilisé comme condensateur de liaison. De façon symétrique, un condensateur 41, de même capacité que le condensateur 40, est placé entre le point milieu de la bobine B31 et l'élément de charge 30.

Par ailleurs, on noter que, lors d'une émission, la seconde partie de chacune des bobines A31 et B31 est parcourue par un courant magnétisant indésirable qui se propage jusqu'en entrée de l'amplificateur 31. Ce courant magnétisant est inversement proportionnel à la valeur d'inductance L de la bobine et inversement proportionnel à la fréquence du signal se propageant à travers la bobine. Pour une fréquence de l'ordre de 2,4 GHz, un rapport de 20 dB entre la puissance d'un signal parasite txa ou txb en entrée de l'amplificateur 31 et la puissance d'un signal tx sur l'entrée E peut être atteint en utilisant des bobines A31 et B31 présentant une inductance de quelques nH.

Selon un mode de mise en oeuvre perfectionné de la présente invention, l'élément de charge 30 présente une impédance Zc variable, ajustable en "dynamique", c'est-à-dire pendant les périodes d'utilisation du circulateur. L'impédance Zc est ajustée de façon à être la plus proche possible de l'impédance de l'antenne 2. Afin d'ajuster en dynamique l'impédance Zc de l'élément de charge, on peut utiliser un dispositif de contrôle 45, représenté en figures 3 et 8, qui modifie, si nécessaire, l'impédance Zc en fonction de la tension relevée en sortie de l'amplificateur différentiel 31. Le dispositif de contrôle 45 permet ainsi de réaliser une boucle d'asservissement de l'impédance Zc de l'élément de charge. Un exemple d'élément de charge d'impédance Zc variable et de dispositif dé contrôle 45 associé sont décrits plus en détails ci-après.

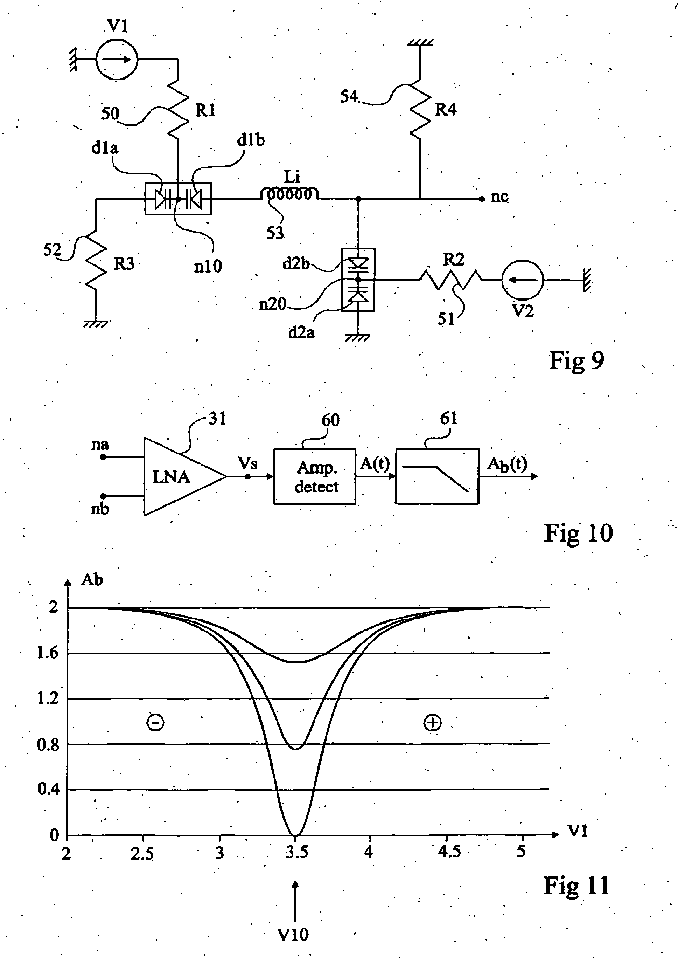

La figure 9 est un schéma d'un exemple de réalisation de l'élément de charge 30 du circulateur représenté en figure 3. Il comprend une source de tension V1 et une résistance 50, de valeur R1, placées en série entre la masse et un noeud intermédiaire n10 reliant les cathodes d'une paire de diodes de type VARACTOR d1a et d1b. Les diodes de type VARACTOR sont également connues sous le nom de diodes à capacité variable. De même, une source de tension V2 et une résistances 51, de valeur R2, sont placées en série entre la masse et un noeud intermédiaire n20 reliant les cathodes d'une paire de diodes de type, VARACTOR d2a et d2b. L'anode de la diode d1a est reliée à la masse par l'intermédiaire d'une résistance 52, de valeur R3. L'anode de la diode d2a est reliée à la masse. Une bobine 53, d'inductance Li, est placée entre les anodes des diodes d1b et d2b. Une résistance 54, de valeur R4, est placée entre la massé et l'anode de la diode d2b. L'anode de la diode d2b, la résistance 54 et la bobine 53 sont reliées à un noeud de connexion nc destiné à être relié à la borne n°1 du coupleur B du circulateur représenté en figure 3.

La capacité équivalente Cd1 de la paire de diodes d1a/d1b est fonction de la tension V1. Plus la tension V1 est élevée, plus la capacité Cd1 est faible. De même, la capacité équivalente Cd2 de la paire de diodes d2a/d2b est fonction de la tension V2. Plus la tension V2 est élevée, plus la capacité Cd2 est faible.

L'impédance Zc de l'élément de charge 30 peut être définie sous la forme d'un nombre complexe Zc= zr + j*zi, où j est la variable complexe et zr et zi des nombres réels correspondant aux parties réelle et imaginaire de Zc. Au premier ordre, la partie réelle zr est fixée par la tension V2 et la partie imaginaire zi est fixée par la tension V1.

A titre indicatif, et non limitatif, les caractéristiques des composants de l'élément de charge sont les suivantes :
résistance R1 : 1,8 kOhms ;
résistance R2 : 1,8 kOhms ;
résistance R3 : 20 Ohms ;
résistance R4 : 4 kOhms ;
inductance Li : 3,43 nH ;
Cd1 pour V1 = 0, 2 et 4 V : 7 pF;
Cd1 pour V2 = 0, 2 et 4 V : 3,81 pF.

L'homme de l'art pourra imaginer d'autres éléments de charge que celui représenté en figure 9. On utilisera de préférence un élément de charge dont l'impédance Zc est très peu sensible aux variations de puissance du signal appliqué à ses bornes afin d'éviter des problèmes de distorsion des signaux se propageant à travers le circulateur.

Un avantage de l'élément de charge représenté en figure 9 est que son impédance Zc est très peu sensible aux variations de puissance du signal appliqué au noeud nc.

Un exemple de dispositif de contrôle 45 pouvant être utilisé en association avec l'élément de charge représenté en figure 9 pour réaliser une boucle d'asservissement de l'impédance Zc de l'élément de charge en fonction des variations d'impédance de l'antenne 2 est décrit ci-après.

La figure 10 est un schéma illustrant une partie du dispositif de contrôle 45. Un dispositif de calcul 60 reçoit la tension Vs (t) fournie par l'amplificateur LNA 31 sur la sortie S du dispositif et fournit une tension A(t) correspondant à l'amplitude de la tension Vs. Un filtre passe-bas 61 "extrait" la partie basse fréquence du signal A(t) et fournit une tension A_{b} (t). La tension A_{b} (t) est fonction des valeurs des tensions V1 et V2 appliquées dans l'élément de charge 30. Ainsi, la tension A_{b} peut être définie au moyen d'une fonction F ayant deux variables d'entrées, les tensions V1 et V2, A_{b} =F(V1, V2).

La figure 11 est un diagramme indiquant la valeur de la tension A_{b} en fonction de la tension V1, pour différentes valeurs de la tension V2. -Il apparaît que, quelle que soit la tension V2, la tension A_{b} décroît quand la tension V1 passe de 0 V à une valeur V10, égale à 3, 5 V dans cet exemple, et que la tension A_{b} croît quand la tension V1 passe de la valeur V10 à une valeur maximale possible pour V1. Par conséquent, là dérivée de la tension A_{b} par rapport à V1 est négative quand V1 est inférieure à V10, et positive quand V1 est supérieure à V10.

Les variations de la tension A_{b} en fonction de la tension V2 pour différentes valeurs de la tension V1 sont identiques à celles décrites précédemment.

Le réglage des tensions V1 et V2 par le dispositif de contrôle 45 s'effectue en deux temps. On commence par ajuster l'une des deux tensions, par exemple la tension V1, sans changer l'autre. On ajuste ensuite la seconde tension, la tension V2 dans notre exemple, la tension V1 étant fixée. Le but du réglage est d'obtenir au final une tension A_{b} nulle.

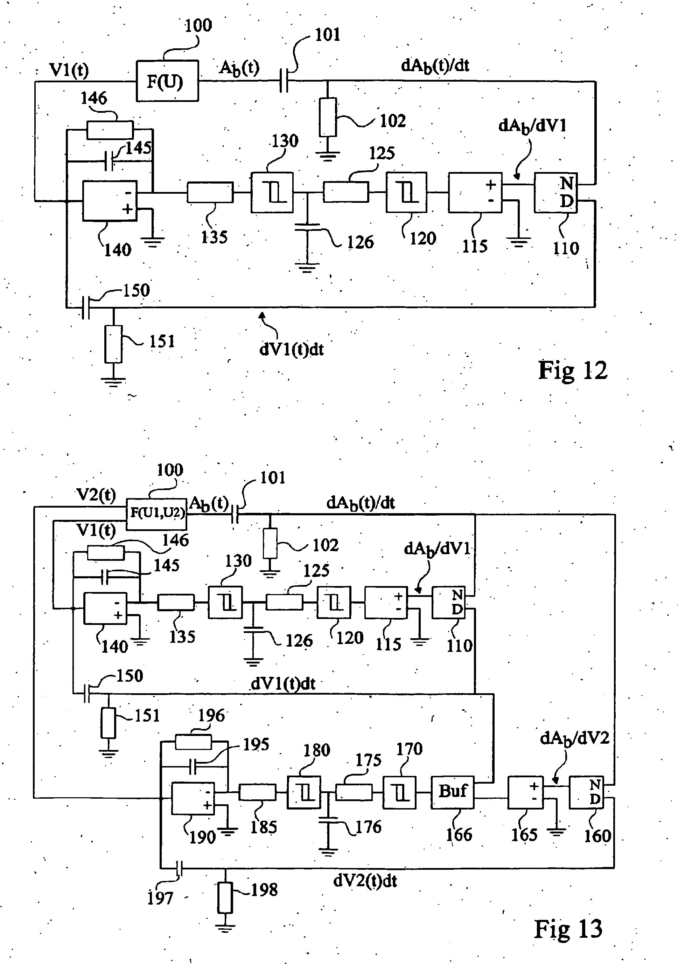

La figure 12 est un schéma illustrant une partie du dispositif de contrôle 45, représenté en figure 3, permettant de régler la tension V1. Un bloc 100 inclut les éléments du circulateur autres que le dispositif de contrôle 45 ainsi que le dispositif de calcul 60 et le filtre passe-bas 61 du dispositif de contrôle 45. Le bloc 100 modifie la tension A_{b} en fonction des variations de la tension V1 selon la fonction F précédemment décrite. La tension A_{b} et la tension V1 varient au cours du temps en fonction des variations d'impédance de l'antenne 2, 1a notation A_{b}(t) et V1(t) permet de tenir compte de ces variations temporelles.

Le dispositif de contrôle 45 comprend les éléments suivants. Une électrode d'un condensateur 101 est reliée à la sortie du filtre passe-bas 61 représenté en figure 10. Une résistance 102 est placée entre l'autre électrode du condensateur 101 et la masse. Le noeud intermédiaire entre le condensateur 101 et la résistance 102 est relié à une entrée "nominateur" N d'un bloc diviseur 110. La sortie du bloc diviseur 110 est connectée à une borne positive d'un bloc comparateur 115 dont la borne négative est connectée à la masse. La sortie du bloc comparateur 115 est connectée à un bloc de type bascule de Schmitt 120, plus connu sous le terme anglais "Schmitt trigger". La sortie du bloc 120 est connectée à une borne d'une résistance 125. Un condensateur 126 est placé entre l'autre borne de la résistance 125 et la masse. Le noeud intermédiaire entre la résistance 125 et le condensateur 126 est connecté à l'entrée d'un bloc de type bascule de Schmitt 130. La sortie du bloc 130 est connectée à une borne d'une résistance 135. L'autre borne de la résistance 135 est connectée à une entrée négative d'un amplificateur, 140 dont l'entrée positive est connectée à la masse. Une condensateur 145 et une résistance 146 sont placés en parallèle entre la sortie et l'entrée négative de l'amplificateur 140. La sortie de l'amplificateur 140 fournit la tension V1 (t) qui est appliquée dans l'élément de charge 30 inclus dans le bloc 100. La sortie de l'amplificateur 140 est connectée à une électrode d'un condensateur 150. Une résistance 151 est placée entre la masse et l'autre électrode du condensateur 150. Le noeud intermédiaire entre le condensateur 150 et la résistance 151 est connecté à une entrée "dénominateur" D du bloc diviseur 110.

Le condensateur 101 et la résistance 102 constituent un dispositif dérivateur, la valeur de la tension fournie sur l'entrée N du bloc diviseur 110 correspondant à la dérivée de la tension A_{b} en fonction du temps (dA_{b}(t)/dt).

Le condensateur 150 et la résistance 151 constituent un autre dispositif dérivateur. La valeur de la tension fournie sur l'entrée D du bloc diviseur 110 correspond à la dérivée de la tension V1 en fonction du temps (dV1 (t) /dt).

La valeur fournie en sortie du bloc diviseur 110 correspond à la dérivée de la tension A_{b} en fonction de la tension V1 (dA_{b}(t)/dV1).

La valeur fournie en sortie du comparateur 115 indique le signe de la dérivée de la tension A_{b} en fonction de la tension V1.

La résistance 125 et le condensateur 126 constituent un filtre passe-bas. Ces filtres passe-bas et les blocs de type bascule de Schmitt 120 et 130 servent à stabiliser la boucle d'asservissement.

L'amplificateur 140, le condensateur 145 et les résistances 135 et 146 constituent un dispositif intégrateur. Quand le signe de dA_{b}/dV1 est positif, le dispositif intégrateur diminue la tension V1 et inversement.

Quand la dérivée de la tension A_{b} en fonction du temps s'annule, dA_{b}(t)/dt=0, la tension V1 est réglée. On passe alors au réglage de la tension V2.

La figure 13 est, un schéma complet du dispositif de contrôle 45. Outre les éléments décrits en relation avec la figure 12, il comprend les éléments suivants. Le noeud intermédiaire entre le condensateur 101 et la résistance 102 est connecté à une entrée "nominateur" N d'un bloc diviseur 160. La sortie du bloc diviseur 160 est connectée à une borne positive d'un bloc comparateur 165 dont la borne négative est connectée à la masse. La sortie du bloc comparateur 165 est connectée à une entrée d'un dispositif tampon 166. Une autre entrée du dispositif tampon 166 est connectée au noeud intermédiaire entre le condensateur 150 et la résistance 151. La sortie du dispositif tampon 166 est connectée à un bloc de type bascule de Schmitt 170. La sortie du bloc 170 est connectée à une borne d'une résistance 175. Un condensateur 176 est placé entre l'autre borne de la résistance 175 et la masse. Le noeud intermédiaire entre la résistance 175 et le condensateur 176 est connecté à l'entrée d'un bloc de type bascule de Schmitt 180. La sortie du bloc 180 est connectée à une borne d'une résistance 185. L'autre borne de la résistance 185 est connectée à une entrée négative d'un amplificateur opérationnel 190 dont l'entrée positive est connectée à la masse. Un condensateur 195 et une résistance 196 sont placés en parallèle entre la sortie et l'entrée négative de l'amplificateur 190. La sortie de l'amplificateur 190 fournit la tension V2 (t) qui est appliquée dans l'élément de charge 30 inclus dans le bloc 100. La sortie de l'amplificateur 190 est connectée à une électrode d'un condensateur 197. Une résistance 198 est placée entre la masse et l'autre électrode du condensateur 197. Le noeud intermédiaire entre le condensateur 197 et la résistance 198 est connecté à une entrée "dénominateur" D du bloc diviseur 160.

Le dispositif tampon 166 est prévu pour fournir en sortie une tension nulle quand la valeur de dV1 (t) /dt est non nulle, c'est-a-dire tant que le réglage de la tension V1 n'est pas finalisé, et une tension sensiblement égale à la tension fournie par le bloc comparateur 165 quand le réglage de la tension V1 est finalisé. Le fonctionnement des autres éléments, ayant des préférences comprises entre 160 et 198, est identique au fonctionnement décrit précédemment des éléments ayant des références comprises entre 110 et 151.

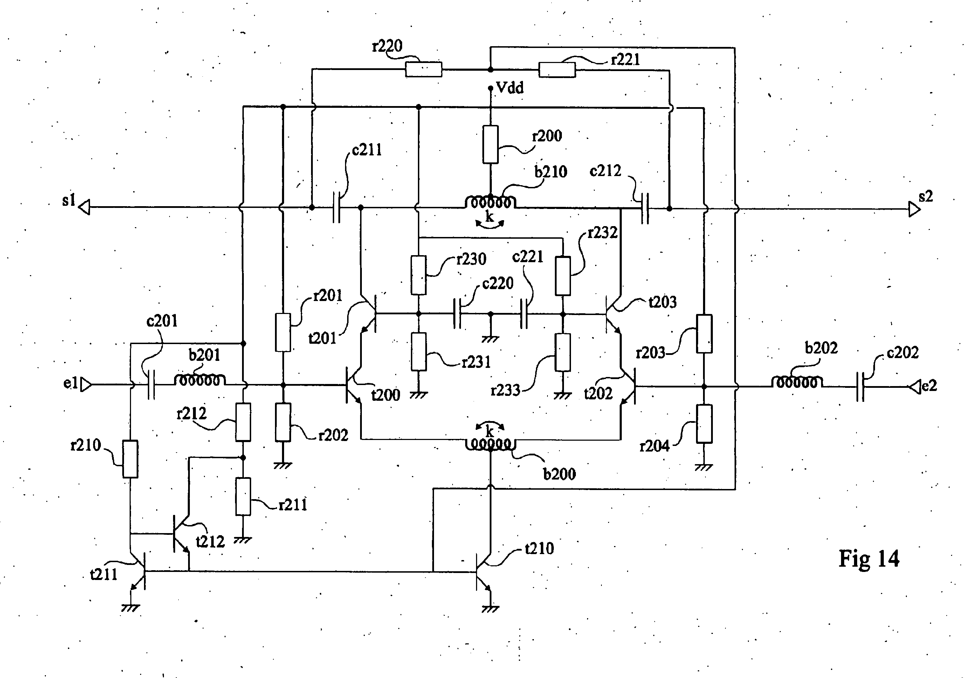

La figure 14 est un schéma d'un étage d'entrée d'un amplificateur différentiel pouvant être utilisé dans un circulateur selon la présente invention. Ce premier étage comprend deux branches constituées chacune d'une paire de transistors bipolaires de type NPN t200, t201 et t202, t203 montés en cascode. Le collecteur du transistor t200 est connecté à l'émetteur du transistor t201 et le collecteur du transistor t202 est connecté à l'émetteur du transistor t203. Les émetteurs des transistors t200 et t202 sont reliés par l'intermédiaire d'une bobine à point milieu b200. La base du transistor t200 est reliée à une entrée e1 de l'amplificateur par l'intermédiaire d'une bobine b201 et d'un condensateur c201 en série. De même, la base du transistor t202 est reliée à une entrée e2 de l'amplificateur par l'intermédiaire d'une bobine b202 et d'un condensateur c202 en série. Le collecteur du transistor t201 est relié à une sortie s1 par l'intermédiaire d'un condensateur c211. De même, le collecteur du transistor t203 est relié à une sortie s2 par l'intermédiaire d'un condensateur c212. Les collecteurs des transistors t201 et t203 sont reliés par l'intermédiaire d'une bobine à point milieu b210. Une résistance r200 est placée entre le point milieu de la bobine b210 et une tension d'alimentation Vdd. Deux résistances r201 et r202 sont placées en série entre la tension Vdd et la masse, le noeud intermédiaire entre les résistances r201 et r202 étant relié à la base du transistor t200. Deux résistances r203 et r204 sont placées en série entre la tension Vdd et la masse, le noeud intermédiaire entre les résistances r203 et r204 étant relié à la base du transistor t202. Le point milieu de la bobine b200 est connecté au collecteur d'un transistor t210 dont l'émetteur est connecté à la masse. La base du transistor t210 est connectée à la base d'un transistor t211. L'émetteur du transistor t211 est connecté à la masse. Le collecteur du transistor t211 est connecté à la base d'un transistor t212. L'émetteur du transistor t212 est connecté à la base du transistor t211. Une résistance r210 est placée entre la tension d'alimentation Vdd et le collecteur du transistor t211. Deux résistances r211 et r212 sont placées en série entre la tension Vdd et la masse. Le noeud intermédiaire entre les résistances r211 et r212 est connecté au collecteur du transistor t212. Les sorties s1 et s2 sont reliées par deux résistances en série r220 et r221. Le noeud intermédiaire entre les résistances r220 et r221 est connecté à la base du transistor t210. Un condensateur c220 est placé entre la base du transistor t201 et la masse. De même, un condensateur c221 est placé entre la base du transistor t203 et la masse. Deux résistances r230 et r231 sont placées en série entre la tension Vdd et la masse, le noeud intermédiaire entre les résistances r230 et r231 étant relié à la base du transistor t201. De même, deux résistances r232 et r233 sont placées en série entre la tension Vdd et la masse, le noeud intermédiaire entre les résistances r232 et r233 étant relié à la base du transistor t203.

Dans ce premier étage de l'amplificateur, les transistors t210, t211 et t212, et les résistances r210, r211, r212 forment un miroir de courant. Ce miroir de courant constitue une source de courant pour les deux branches principales de l'amplificateur constituées des paires de transistors t200/t201 et t202/t203. Les condensateurs c220, c221 et les résistances. r230 à r233 constituent un circuit de polarisation des bases des transistors t201 et t203.

Par ailleurs, les résistances r220 et r221 et leur liaison avec la base du transistor 210 constituent un dispositif de régulation de la valeur du courant fourni par la source de courant alimentant les deux branches principales. Quand des signaux identiques, en phase et en amplitude, sont reçus sur les entrées e1 et e2, par exemple lors de la réception de signaux parasites txa et txb, le courant fourni par la source de courant augmente ou diminue selon que la puissance des signaux reçus est élevée ou faible.

La présence du dispositif dé régulation dans l'amplificateur différentiel permet d'augmenter son taux de réjection en mode commun (TRMC). Les capacités de détection et d'amplification de l'amplificateur sont alors très peu sensibles aux signaux parasites txa et txb. Lors de la réception d'un signal électromagnétique Rx, l'amplificateur peut alors détecter et amplifier des signaux dérivés rxa et rxb de très faible puissance, sans que l'émission simultanée d'un signal électromagnétique Tx de forte puissance ne perturbe le fonctionnement de l'amplificateur.

Un avantage d'un circulateur selon la présente invention est qu'un terminal équipé d'un tel circulateur peut détecter un dispositif transpondeur beaucoup plus éloigné sans qu'il soit nécessaire que le dispositif transpondeur dispose d'une batterie interne.

A titre indicatif, et non limitatif, un circulateur selon la présente invention permet d'émettre un signal électromagnétique Tx présentent une puissance de l'ordre de 30 mW (15 dBm), et de recevoir simultanément un signal électromagnétique Rx présentant une puissance minimale de l'ordre de 0,1 nW (-70 dBm)

Bien entendu, la présente invention est susceptible de diverses variantes et modifications qui apparaîtront à l'homme de l'art. En particulier, l'homme de l'art pourra imaginer d'autres modes de réalisation d'un coupleur. De plus, d'autres éléments de charge et d'autres circuits de contrôle peuvent être imaginés.

Par ailleurs, les coupleurs A, B et l'amplificateur différentiel 31 du circulateur selon la présente invention représenté en figure 3 front partie d'un même circuit intégré, ou autrement dit d'un même dispositif monolithique. L'élément de charge 30, le dispositif de contrôle 45 et l'antenne 2 peuvent faire partie de ce même circuit intégré ou être réalisés en dehors de ce circuit intégré et être reliés à ce dernier.

## Revendications

1. Circulateur monolithique, destiné à être replié à une antenne (2) pour émettre et recevoir des signaux haute fréquence, comprenant :
un amplificateur différentiel (31) à deux entrées apte à fournir un signal sur une sortie (S) du circulateur, et
deux coupleurs 3dB (A, B) comportant chacun des première, deuxième et troisième bornes d'accès, les deuxièmes bornes étant connectées à une entrée E du circulateur, chaque troisième borne étant connectée à une entrée de l'amplificateur, les premières bornes étant respectivement destinées à être reliées à l'antenne et à un élément de charge (30) présentant une impédance proche de celle de l'antenne.

2. Circulateur selon la revendication 1, dans lequel chaque coupleur comporte une résistance (A30, B30) et une bobine à point milieu (A31, B31) placées en parallèle entre ses première et troisième bornes, les deux parties de chaque bobine à point milieu étant couplées magnétiquement, le point milieu d'une bobine d'un coupleur étant connecté à sa première borne.

3. Circulateur selon la revendication 2, dans lequel chaque coupleur comprend en outre un condensateur (A32, B32) en parallèle sur la résistance (A30, B30) et la bobine à point milieu (A31, B31) du coupleur considéré.

4. Circulateur selon la revendication 2, dans lequel l'impédance de l'antenne (2) est proche de celle d'une résistance de valeur R, la valeur des résistances (A30, B30) de chacune coupleur étant environ égale à quatre, fois R, l'impédance d'une entrée de l'amplificateur différentiel étant environ égale à deux fois R, l'impédance de sortie d'un circuit connecté sur l'entrée (E) du circulateur étant environ égale à deux fois R.

5. Circulateur selon la revendication 1, dans lequel l'impédance (Zc) de l'élément de charge (30) est réglable.

6. Circulateur selon la revendication 5, comprenant un circuit de contrôle (45) apte à modifier l'impédance (Zc) de l'élément de charge (30) en fonction de la tension relevée en sortie (S) de l'amplificateur différentiel.

7. Circulateur selon la revendication 5, dans lequel l'élément de charge (30) comprend une première résistance (50) et une première source de tension (V1) en série entre la masse et un premier noeud intermédiaire (n10) entre les cathodes de deux premières diodes de type varactor (d1a, d1b), une seconde résistance (51) et une seconde source de tension (V2) en série entre la masse et un second noeud intermédiaire (n20) entre les cathodes de deux secondes diodes de type varactor (d2a, d2b), l'anode de l'une des premières diodes étant reliée à la masse par l'intermédiaire d'une troisième résistance (52), l'anode d'une des secondes diodes étant connectée à la masse, l'autre des secondes diodes étant reliée à la masse par l'intermédiaire d'une quatrième résistance (54), une bobine (53) étant placée entre l'anode de l'autre des premières diodes et l'anode de l'autre des secondes diodes.

8. Circulateur selon les revendications 6 et 7, dans lequel le circuit de contrôle (45) comprend un premier ensemble de blocs qui reçoit la sortie du circulateur et qui est relié à des première et seconde boucles d'asservissement, le premier ensemble de blocs comprenant un dispositif d'extraction de l'amplitude du signal en sortie du circulateur, suivi d'un filtre passe-bas et d'un dispositif dérivateur, chaque boucle d'asservissement comprenant les éléments suivants : un bloc diviseur (110, 160) recevant sur une entrée nominateur (N) la sortie du dispositif dérivateur, la sortie du bloc diviseur étant connectée à une borne positive d'un comparateur (115, 165), la sortie du comparateur étant reliée à un dispositif de stabilisation dont la sortie est connectée à l'entrée d'un bloc intégrateur, un bloc dérivateur étant placé entre la sortie du bloc intégrateur et une entrée dénominateur (D) du bloc diviseur, la seconde boucle comprenant en outre un bloc tampon (166) placé entre son comparateur et son dispositif de stabilisation et recevant la sortie du bloc dérivateur de la première boucle, la sortie du bloc tampon étant égale à la sortie du comparateur de la seconde boucle ou nulle selon que 1a sortie du bloc dérivateur de la première boucle est respectivement nulle ou non nulle, les sorties des blocs intégrateurs des première et seconde boucles fournissant respectivement des tensions égales aux tensions appliquées par les première et seconde sources de tension (V1, V2) de l'élément de charge (30).

9. Circulateur selon la revendication 8, dans lequel le dispositif dérivateur est constitué d'un condensateur (101) et d'une résistance (102) en série placés entre la sortie du filtre passe-bas et la masse, le noeud intermédiaire entre le condensateur et la résistance étant connectée aux entrées N des blocs diviseurs (110, 160) des boucles d'asservissement,
dans lequel le dispositif de stabilisation de chaque boucle d'asservissement comprend des première et seconde bascules de Schmitt (120, 130 ; 170, 180), l'entrée de la première bascule étant reliée au comparateur (115 ; 165) de la boucle considérée, une première résistance (125 ; 175) placée entre les bascules, un condensateur (126 ; 176) placé entre l'entrée de la seconde bascule et la masse et une seconde résistance (135 ; 185) placée entre la sortie de la seconde bascule et l'entrée du bloc intégrateur de la boucle d'asservissement considérée,
dans lequel le bloc dérivateur de chaque boucle d'asservissement comprend un condensateur (150 ; 197) et une résistance (151 ; 198) en série entre l'entrée du bloc et la masse, le noeud intermédiaire entre le condensateur et la résistance constituant la sortie du bloc, et
dans lequel le bloc intégrateur de chaque boucle d'asservissement comprend un amplificateur différentiel (140 ; 190) ainsi qu'un condensateur (145 ; 195) et une résistance (146; 196) placés en parallèle entre la sortie et l'entrée négative de l'amplificateur différentiel, les bornes positive et négative de l'amplificateur étant respectivement connectées à la masse et à la sortie du dispositif de stabilisation de la boucle considérée.

10. Terminal de réception et d'émission de signaux électromagnétiques comprenant un circulateur selon l'une quelconque des revendications 1 à 9, le circulateur étant relié à une antenne.

## Claims

1. A monolithic circulator, intended to be connected to an antenna (2) for transmitting and receiving high-frequency signals, comprising:
a differential two-input amplifier (31) capable of providing a signal on an output (S) of the circulator, and
two 3dB couplers (A, B) each comprising first, second, and third access terminals, the second terminals being connected to an input (E) of the circulator, each third terminal being connected to an input of the amplifier, the first terminals being respectively intended to be connected to the antenna and to a charge element (30) having an impedance close to that of the antenna.

2. The circulator of claim 1, wherein each coupler comprises a resistor (A30, B30) and a coil with a midpoint (A31, B31), placed in parallel between its first and third terminals, the two parts of each coil with a midpoint being magnetically coupled, the midpoint of a coil of a coupler being connected to its first terminal.

3. The circulator of claim 2, wherein each coupler further comprises a capacitor (A32, B32) in parallel on the resistor (A30, B30) and the coil with a midpoint (A31, B31) of the considered coupler.

4. The circulator of claim 2, wherein the impedance of the antenna (2) is close to that of a resistance of value R, the value of the resistances (A30, B30) of each coupler being approximately equal to four times R, the impedance of an input of the differential amplifier being approximately equal to twice R, the output impedance of a circuit connected on the input (E) of the circulator being approximately equal to twice R.

5. The circulator of claim 1, wherein the impedance (Zc) of the charge element (30) is settable.

6. The circulator of claim 5, comprising a control circuit (45) capable of modifying the impedance (Zc) of the charge element (30) according to the voltage measured at the output (S) of the differential amplifier.

7. The circulator of claim 5, wherein the charge element (30) comprises a first resistor (50) and a first voltage source (V1) in series between the ground and a first intermediary node (n10) between the cathodes of two first varactor-type diodes (d1a, d1b), a second resistor (51) and a second voltage source (V2) in series between the ground and a second intermediary node (n20) between the cathodes of two second varactor-type diodes (d2a, d2b), the anode of one of the first diodes being grounded via a third resistor (52), the anode of one of the second diodes being grounded, the other one of the second diodes being grounded via a fourth resistor (54), a coil (53) being placed between the anode of the other one of the first diodes and the anode of the other one of the second diodes.

8. The circulator of claims 6 and 7, wherein the control circuit (45) comprises a first block assembly which receives the output of the circulator and which is connected to first and second control loops, the first block assembly comprising a device for extracting the amplitude of the output signal of the circulator, followed by a low-pass filter and a differentiating device, each control loop comprising the following elements: a dividing bridge (110, 160) receiving on a numerator input (N) the output of the differentiating device, the output of the dividing bridge being connected to a positive terminal of a comparator (115, 165), the output of the comparator being connected to a stabilizing device having its output connected to the input of an integrating block, a differentiating block being placed between the output of the integrating block and a denominator input (D) of the dividing block, the second loop further comprising a buffer block (166) placed between its comparator and its stabilizing device and receiving the output of the differentiating block of the first loop, the output of the buffer block being equal to the output of the comparator of the second loop or to zero according to whether the output of the differentiating block of the first loop is respectively zero or non-zero, the outputs of the integrating blocks of the first and second loops respectively providing voltages equal to the voltages applied by the first and second voltage sources (V1, V2) of the charge element (30).

9. The circulator of claim 8, wherein the differentiating device is formed of a capacitor (101) and of a resistor (102) in series placed between the output of the low-pass filter and the ground, the intermediary node between the capacitor and the resistor being connected to the N inputs of the dividing blocks (110, 160) of the control loops,
wherein the stabilizing device of each control loop comprises first and second Schmitt triggers (120, 130; 170, 180), the input of the first trigger being connected to the comparator (115; 165) of the considered loop, a first resistor (125; 175) placed between the triggers, a capacitor (126; 176) placed between the input of the second trigger and the ground, and a second resistor (135; 185) placed between the output of the second trigger and the input of the integrating block of the considered control loop,
wherein the differentiating block of each control loop comprises a capacitor (150; 197) and a resistor (151; 198) in series between the input of the block and the ground, the intermediary node between the capacitor and the resistor forming the block output, and
wherein the integrating block of each control loop comprises a differential amplifier (140; 190) as well as a capacitor (145; 195) and a resistor (146; 196) placed in parallel between the output and the negative input of the differential amplifier, the positive and negative terminals of the amplifier being respectively connected to ground and to the output of the stabilizing device of the considered loop.

10. A terminal for receiving and transmitting electromagnetic signals comprising a circulator according to any of claims 1 to 9, the circulator being connected to an antenna.

## Patentansprüche

1. Ein monolithischer Zirkulator, verbindbar mit einer Antenne (2) zum Senden und Empfangen von Hochfrequenzsignalen, der Folgendes aufweist:
ein Differenz-Zwei-Eingangs-Verstärker (31), der in der Lage ist zum Vorsehen eines Signals an einem Ausgang (S) des Zirkulators, und
zwei 3dB-Koppler (A, B), wobei jeder davon erste, zweite und dritte Zugriffsanschlüsse aufweist, wobei die zweiten Anschlüsse mit einem Eingang (E) des Zirkulators verbunden sind, wobei jeder dritte Anschluss mit einem Eingang des Verstärkers verbunden ist, wobei die ersten Anschlüsse entsprechend verbindbar sind mit der Antenne und mit einem Ladeelement (30), das eine Impedanz hat, die in der Nähe der Impedanz der Antenne liegt.

2. Zirkulator nach Anspruch 1, wobei jeder Koppler einen Widerstand (A30, B30) und eine Spule mit einem Mittelpunkt (A31, B31) aufweist, platziert parallel zwischen seinen ersten und dritten Anschlüssen, wobei die zwei Teile von jeder Spule mit einem Mittelpunkt magnetisch gekoppelt sind, wobei der Mittelpunkt einer Spule eines Kopplers mit seinem ersten Anschluss verbunden ist.

3. Zirkulator nach Anspruch 2, wobei jeder Koppler weiterhin einen Kondensator (A32, B32) parallel zum Widerstand (A30, B30) und der Spule mit einem Mittelpunkt (A31, B31) des betrachteten Kopplers aufweist.

4. Zirkulator nach Anspruch 2, wobei die Impedanz der Antenne (2) in der Nähe der Impedanz eines Widerstands mit dem Wert R ist, wobei der Wert der Widerstände (A30, B30) jedes Kopplers näherungsweise gleich viermal R ist, wobei die Impedanz eines Eingangs des differenziellen Verstärkers bzw. Differenzverstärkers näherungsweise gleich zweimal R ist, wobei die Ausgangsimpedanz eines Schaltkreises, der mit dem Eingang (E) des Zirkulators verbunden ist, näherungsweise gleich zweimal R ist.

5. Zirkulator nach Anspruch 1, wobei die Impedanz (Zc) des Ladeelements (30) einstellbar ist.

6. Zirkulator nach Anspruch 5, der einen Steuerschaltkreis (45) aufweist, der in der Lage ist zu Modifizieren der Impedanz (Zc) des Ladeelements (30) gemäß der Spannung, die beim Ausgang (S) des differenziellen Verstärkers bzw. Differenzverstärkers gemessen wird.

7. Zirkulator nach Anspruch 5, wobei das Ladeelement (30) einen ersten Widerstand (50) und eine erste Spannungsquelle (V1) in Serie zwischen der Masse und einem ersten dazwischen liegendem Knoten (n10) zwischen den Kathoden der zwei ersten Varactor-Typ Dioden (d1a, d1b), einen zweiten Widerstand (51) und eine zweite Spannungsquelle (V2) in Serie zwischen der Masse und einem zweiten dazwischen liegendem Knoten (n20) zwischen den Kathoden der zwei zweiten Varactor-Typ Dioden (d2a, d2b) aufweist, wobei die Anode von einer der ersten Dioden über einen dritten Widerstand (52) mit der Masse verbunden ist, wobei die Anode von einer der zweiten Dioden mit der Masse verbunden ist, wobei die andere der zweiten Dioden über einen vierten Widerstand (54) mit der Masse verbunden ist, wobei eine Spule (53) zwischen der Anode der anderen der ersten Dioden und der Anode der anderen der zweiten Dioden platziert ist.

8. Zirkulator nach den Ansprüchen 6 und 7, wobei der Steuerschaltkreis (45) eine erste Blockbaugruppe aufweist, die den Ausgang des Zirkulators empfängt und, die verbunden ist mit ersten und zweiten Steuerschleifen, wobei die erste Blockbaugruppe eine Einheit aufweist zum Extrahieren der Amplitude des Ausgangssignals des Zirkulators, gefolgt von einem Tiefpassfilter und von einer differenzierenden Einheit bzw. Differenzeinheit, wobei jede Steuerschleife die folgenden Elemente aufweist:
eine Teilereinheit (110, 160), die an einem Numerator-Eingang (N) den Ausgang des differenzierenden Gerätes empfängt, wobei der Ausgang der Teilereinheit mit einem positiven Anschluss eines Vergleichers (115, 165) verbunden ist, wobei der Ausgang des Vergleichers mit einer Stabilisierungseinheit verbunden ist, mit seinem Ausgang verbunden mit dem Eingang eines Integrierblocks, wobei ein Differenzblock zwischen dem Ausgang des Integrierblocks und einem Denominator-Eingang (D) der Teilereinheit platziert ist, wobei die zweite Schleife weiterhin einen Puffer-Block (166) aufweist, der zwischen seinem Vergleicher und seiner Stabilisierungseinheit platziert ist und den Ausgang des Differenzblocks der ersten Schleife empfängt, wobei der Ausgang des Pufferblocks gleich dem Ausgang des Vergleichers der zweiten Schleife ist, oder Null ist, gemäß, ob der Ausgang des Differenzierblocks der ersten Schleife entsprechend Null oder nicht Null ist, wobei die Ausgänge der Integrierblöcke der ersten und zweiten Schleifen entsprechend Spannungen vorsehen, und zwar gleich den Spannungen, die von den ersten und zweiten Spannungsquellen (V1, V2) des Ladeelements (30) angewandt werden.

9. Zirkulator nach Anspruch 8, wobei die Differenzeinheit gebildet ist aus einem Kondensator (101) und aus einem Widerstand (102) in Serie platziert zwischen dem Ausgang des Tiefpassfilters und der Masse, wobei der dazwischen liegende Knoten zwischen dem Kondensator und dem Widerstand verbunden ist mit den N Eingängen der Teilerblöcke (110, 160) der Steuerschleifen,
wobei die Stabilisierungseinheit jeder Steuerschleife erste und zweite Schmitt-Trigger (120, 130; 170, 180) aufweist, wobei der Eingang des ersten Triggers verbunden ist mit dem Vergleicher (115; 165) der betrachteten Schleife, ein erster Widerstand (125, 175) platziert ist zwischen den Triggern, ein Kondensator (126; 176) platziert ist zwischen dem Eingang des zweiten Triggers und der Masse, und ein zweiter Widerstand (135; 185) platziert ist zwischen dem Ausgang des zweiten Triggers und dem Eingang des Integrierblocks der betrachteten Steuerschleife,
wobei der Differenzierblock jeder Steuerschleife Folgendes aufweist:
einen Kondensator (150; 197) und einen Widerstand (151; 198) in Serie zwischen dem Eingang des Blocks und der Masse, wobei der dazwischen liegende Knoten zwischen dem Kondensator und dem Widerstand den Blockausgang bildet, und
wobei der Integrierblock jeder Steuerschleife Folgendes aufweist:
einen differenziellen Verstärker bzw. Differenzverstärker (140; 190) wie auch einen Kondensator (145; 195) und einen Widerstand (146; 196) platziert parallel zwischen dem Ausgang und den negativen Eingang des differenziellen Verstärkers, wobei die positiven und negativen Anschlüsse des Verstärkers entsprechend verbunden sind mit der Masse und dem Ausgang des Stabilisierungsgerätes der betrachteten Schleife.

10. Ein Terminal bzw. Gerät zum Empfangen und Senden von elektromagnetischen Signalen, das einen Zirkulator gemäß einem der Ansprüche 1 bis 9 aufweist,
wobei der Zirkulator mit einer Antenne verbunden ist.
